# FASCICULE DE BREVET EUROPEEN

(11) **EP 0 920 789 B1**
(45) Date de publication et mention de la délivrance du brevet: **25.10.2000**
(21) Numéro de dépôt: 97937646.4
(22) Date de dépôt: 21.08.1997
(51) Int. Cl.: H05K 7/20

(54) **PROCEDE DE FABRICATION D'UN DISPOSITIF DE DISSIPATION DE L'ENERGIE THERMIQUE PRODUITE PAR DES COMPOSANTS ELECTRONIQUES IMPLANTES SUR UNE CARTE A CIRCUITS IMPRIMES, ET DISPOSITIF AINSI OBTENU**
HERSTELLUNGSVERFAHREN EINER VORRICHTUNG ZUR ABFUHR VON WÄRME,DIE VON AUF EINER LEITERPLATTE ANGEORDNETEN SCHALTKREISEN ERZEUGT WIRD
METHOD FOR MANUFACTURING A DEVICE FOR DISSIPATING THERMAL ENERGY PRODUCED BY ELECTRONIC COMPONENTS EMBEDDED IN A PRINTED CIRCUIT CARD, AND RESULTING DEVICE

(30) Priorité: 23.08.1996 FR 9610405
(43) Date de publication de la demande: 09.06.1999
(73) Titulaire: GIAT INDUSTRIES, 78000 Versailles (FR)
(72) Inventeur: MOREAU, Emmanuel, F-31400 Toulouse (FR); DESSAUX, Christophe, F-82130 Lafrançaise (FR)
(74) Mandataire: Célanie, Christian
(86) Numéro de dépôt international: FR9701510
(87) Numéro de publication internationale: WO9808363

(56) Documents cités:
- DE-A- 3 151 655
- FR-A- 2 654 890
- US-A- 4 974 119
- US-A- 5 403 973
- "HEAT SPREADING MECHANISM FOR REVERSED COMPONENT" IBM TECHNICAL DISCLOSURE BULLETIN, vol. 38, no. 10, 1 octobre 1995, page 325/326 XP000540509

## Description

La présente invention concerne un procédé de fabrication d'un dispositif de dissipation de l'énergie thermique produite par des composants électroniques implantés sur une carte à circuits imprimés, ainsi que le dispositif de dissipation thermique obtenu par ce procédé, cf. par exemple US-A-5 403 973.

Les composants électroniques ont la particularité de s'échauffer lorsqu'ils fonctionnent, et l'élévation de température qui en résulte tend à affecter la fiabilité de fonctionnement de ces composants. Il s'avère donc nécessaire de dissiper cette énergie thermique, mais la densité de plus en plus grande des composants électroniques implantés sur une carte n'est pas de nature à faciliter cette dissipation thermique.

D'une manière générale, le refroidissement des composants électroniques implantés sur une carte est assuré soir par convection, soit par conduction.

Un refroidissement par convection est obtenu par la circulation d'un fluide qui est habituellement une ventilation forcée d'air avec l'extérieur. Cette solution bien qu'efficace nécessite l'installation d'au moins un ventilateur souvent encombrant. En outre, cette solution n'est pas adaptée pour des équipements qui doivent rester étanches vis-à-vis de l'environnement extérieur.

Un refroidissement par conduction consiste à prévoir un drain thermique pour évacuer les calories vers l'extérieur. A titre d'exemple, comme décrit dans le document FR-A-2 654 890, le drain thermique est constitué par une plaque métallique rigide. Cette plaque est montée parallèlement à la carte et reliée thermiquement aux composants électroniques par une lame ou couche intercalaire en un matériau thermiquement conducteur et électriquement isolant qui est en contact avec les composants électroniques d'une part, et avec la plaque métallique d'autre part. Cette plaque est ensuite fixée par un connecteur thermique à une paroi froide qui est le plus souvent le panier métallique qui sert également à fixer la carte.

Un tel dispositif de dissipation thermique est délicat à mettre en oeuvre, notamment au niveau de la mise en contact de la plaque métallique rigide et de la couche intercalaire, étant donné la présence du connecteur thermique qui doit être fixé, tout comme la carte, sur le panier de l'équipement. Dans ces conditions, l'étendue de la surface de contact entre la couche intercalaire et la plaque métallique va notamment dépendre de la précision de fabrication des moyens de fixation de la carte et du connecteur thermique.

L'objet de l'invention telle que revendiquée est de réaliser un dispositif de dissipation thermique par conduction qui soit simple à mettre en oeuvre et sans nécessiter des tolérances de fabrication aussi contraignantes que celles que l'on retrouve dans l'art antérieur précité.

A cet effet, l'invention propose un procédé de fabrication d'un dispositif de dissipation de l'énergie thermique produite par des composants électroniques implantés sur une carte à circuits imprimés, le procédé consistant à déposer sur la carte une première couche d'un premier matériau thermiquement conducteur et électriquement isolant pour recouvrir au moins les pattes de connexion des composants électroniques à refroidir, et à mettre en contact cette première couche avec un drain métallique relié à une masse thermique pour drainer les calories vers l'extérieur de la carte, caractérisé en ce que le procédé consiste à réaliser le drain sous la forme d'une structure souple et poreuse, et à déposer sur le drain une seconde couche d'un second matériau qui adhère à la première couche au travers des pores du drain pour maintenir ce dernier en place sur la carte.

Selon un mode préférentiel de réalisation, le procédé consiste à limiter l'épaisseur du dépôt de la première couche pour isoler électriquement que les pattes de connexion des composants électroniques qui dissipent une énergie thermique importante, et à mettre ensuite en contact direct le drain thermique avec les parties de ces composants non recouvertes par la première couche.

Pour faciliter l'adhérence entre les première et seconde couches, il est avantageux d'utiliser les mêmes matériaux pour réaliser ces deux couches, comme par exemple une résine à base de polyuréthanne qui est déposée par coulage.

Selon une variante du procédé selon l'invention, on réalise la structure métallique souple sous la forme d'une enveloppe ou chaussette dans laquelle la carte est insérée pour assurer également un blindage électromagnétique.

D'une manière générale, la structure métallique souple et poreuse qui forme le drain thermique peut être constituée par une mousse à cellules ouvertes, par un ruban d'une certaine épaisseur ayant une structure globalement en treillis, ou à partir d'au moins un fil plié et replié de manière à former un volume à pores ou à alvéoles communiquantes.

L'invention a également pour objet un dispositif de dissipation thermique qui est fabriqué selon le procédé précité.

Selon un avantage important de l'invention, le drain thermique est emprisonné entre les première et seconde couches, ce qui permet de le maintenir en place sans avoir recours à des moyens de fixation complémentaires.

Selon un autre avantage de l'invention, les composants électroniques qui dissipent le plus d'énergie peuvent être mis directement en contact avec le drain métallique, ce qui améliore l'efficacité du refroidissement par conduction.

D'autres avantages, caractéristiques et détails de l'invention ressortiront de la description explicative qui va suivre faite en référence aux dessins annexés, donnés uniquement à titre d'exemple et dans lesquels :
- la figure 1 est une vue en coupe d'une carte à circuits imprimés qui supporte un ensemble de composants électroniques,
- les figures 2 à 5 illustrent les différentes étapes du procédé selon l'invention pour fabriquer un dispositif de dissipation de l'énergie thermique produite par les composants électroniques de la carte représentée sur la figure 1,
- les figures 6 et 7 illustrent une variante du procédé selon l'invention, et
- la figure 8 est une vue partielle en coupe de la carte pour illustrer une forme de structure du drain thermique utilisé pour évacuer les calories dissipées par les composants électroniques de la carte.

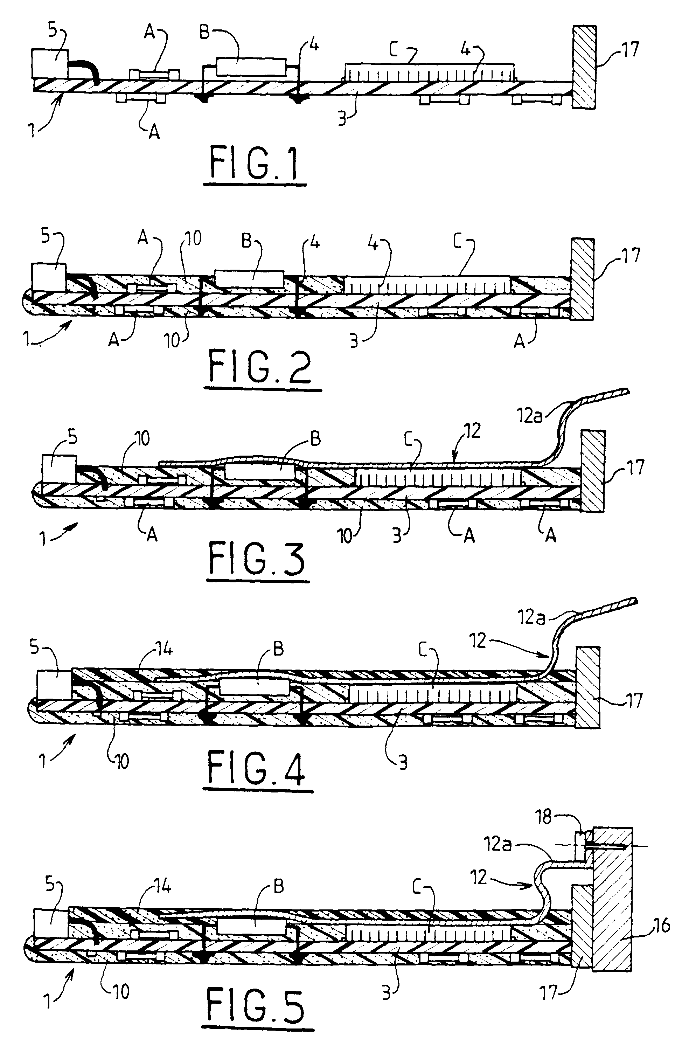

D'une façon connue en soi, une carte électronique 1 telle que celle illustrée sur la figure 1, comprend un substrat 3 en résine époxy qui supporte un ensemble de composants électroniques A, B et C, par exemple. Ces composants ont des pattes de connexion 4 qui sont soudées sur des pistes conductrices (non représentées) déposées sur les deux faces du substrat 3. Un connecteur 5 est fixé sur un bord de la carte 1 pour assurer les liaisons électriques avec l'extérieur.

Les composants électroniques, en particulier le composant B qui peut être un composant de puissance et le composant C qui peut être un circuit intégré, dissipent une énergie thermique importante qu'il est souhaitable de dissiper. A cet effet, on rapporte sur la carte 1 une structure qui permet de dissiper cette énergie thermique selon un procédé de fabrication décrit ci-après.

Dans une première étape illustrée sur la figure 2, on dépose une première couche 10 d'un premier matériau électriquement isolant et thermiquement conducteur. Dans l'exemple illustré, cette première couche 10 est déposée sur les deux faces du substrat 3 de la carte 1, ce qui revient globalement à enrober le substrat 3 de cette première couche 10. Les composants A, tels que des résistances, peuvent être complètement noyés dans cette première couche 10. Par contre, selon un mode préférentiel de fabrication, les composants B et C qui dissipent le plus d'énergie thermique ne sont que partiellement noyés dans cette première couche 10 mais sur une hauteur suffisante pour isoler électriquement les pattes de connexion 4 de ces composants B et C.

A titre d'exemple, le matériau qui est utilisé pour réaliser cette première couche 10 est une résine du type polyuréthanne, qui est coulée sur les deux faces du substrat 3 avant de se solidifier. Cette première couche 10 n'a pas nécessairement une épaisseur constante et une surface nécessairement plane et uniforme.

Dans une seconde étape illustrée sur la figure 3, on rapporte sur au moins la face du substrat 3 qui supporte les deux composants B et C, un drain thermique 12 en un matériau ayant une très bonne conductivité thermique comme le métal. Le drain 12 est mis en contact avec la première couche 10 ainsi que sur les parties supérieures des composants B et C qui ne sont pas recouvertes de cette première couche 10.

Le drain thermique 12 est constitué par une structure métallique souple d'une part et poreuse d'autre part.

La souplesse du drain 12 lui permet de pouvoir épouser la topologie ou la forme de la surface sur laquelle il est déposé, de manière à obtenir une surface de contact la plus grande possible entre la première couche 10, le drain 12 et les composants B et C. On donne au drain 12 des dimensions telles qu'au moins une extrémité libre 12a de celui-ci s'étende au-delà de la surface de la carte 1 pour ne pas être recouverte par la première couche 10.

Dans une troisième étape illustrée sur la figure 4, on assure le maintien en place du drain 12 sur la carte 1. Pour cela, on coule sur le drain 12 une seconde couche 14 d'un second matériau de manière à ce que la porosité du drain 12 permette à ce second matériau de s'écouler au travers des pores du drain 12 pour venir au contact de la première couche 10 et adhérer à celle-ci après solidification.

Avantageusement, la seconde couche 14 est constituée dans le même matériau que celui utilisé pour réaliser la première couche 10, de manière à éviter tout problème d'adhérence entre les deux couches et d'utiliser un agent de liaison intermédiaire.

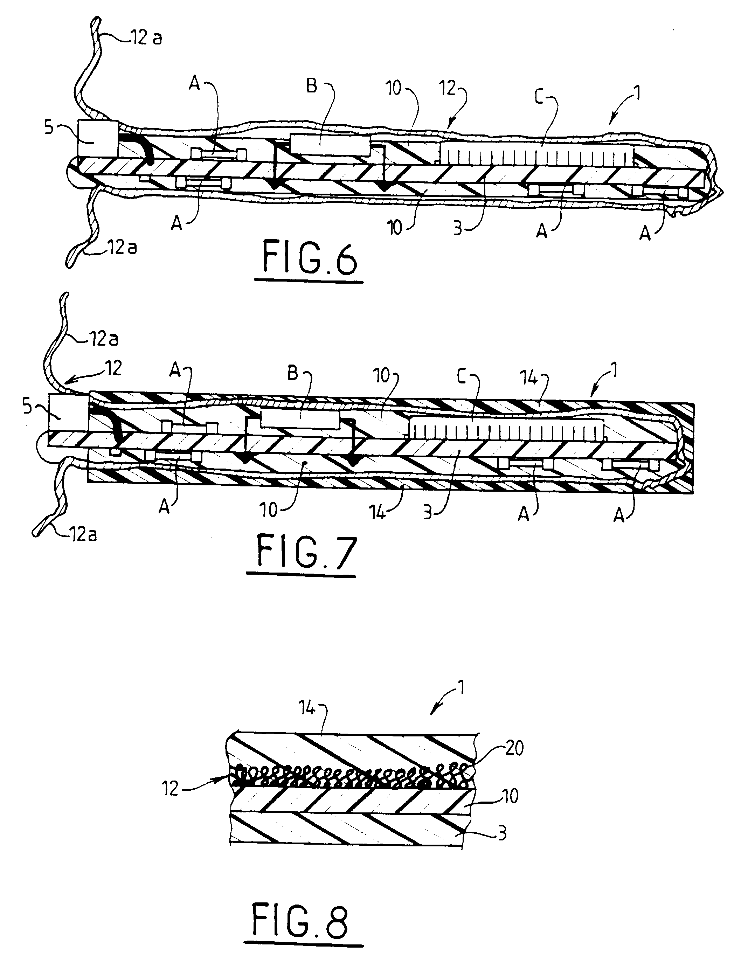

Enfin, dans une quatrième étape illustrée sur la figure 5, lorsque la carte 1 est mise en place et fixée, par exemple, sur un panier métallique 16 d'un équipement électronique au moyen d'un élément de fixation 17, l'extrémité libre 12a du drain 12 est mise au contact d'une masse thermique au moyen d'une vis 18 par exemple, cette masse pouvant être constituée par le panier 16.

Dans une première variante illustrée sur les figures 6 et 7, le drain thermique 12 est constitué par une enveloppe en forme de chaussette dans laquelle est insérée la carte A (figure 6). Ensuite, on enrobe le drain thermique 12 d'une seconde couche 14 pour le maintenir en place (figure 7). Dans cette variante de fabrication, le drain thermique 12 constitue avantageusement un blindage électromagnétique.

Enfin, on a représenté sur la figure 8 un drain thermique 12 constitué par un fil métallique 20 qui est plié et replié de manière à former un volume à pores ou alvéoles communiquantes qui peuvent être traversés par le matériau constituant la seconde couche 14. En variante, le drain 12 peut être constitué par une mousse métallique.

## Revendications

1. Procédé de fabrication d'un dispositif de dissipation de l'énergie thermique produite par des composants électroniques (A, B, C) implantés sur une carte (1) à circuits imprimés, le procédé consistant à déposer sur la carte (1) une première couche (10) d'un premier matériau thermiquement conducteur et électriquement isolant pour recouvrir au moins les pattes de connexion (4) des composants électroniques (A, B, C) à refroidir, et à mettre en contact cette première couche (10) avec un drain métallique (12) relié à une masse thermique pour drainer les calories vers l'extérieur, caractérisé en ce que le procédé consiste à réaliser le drain (12) sous la forme d'une structure souple et poreuse, et à déposer sur le drain (12) une seconde couche (14) d'un second matériau qui adhère à la première couche (10) au travers des pores du drain (12) pour maintenir en place ce dernier sur la carte (1).

2. Procédé selon la revendication 1, caractérisé en ce qu'il consiste à limiter l'épaisseur du dépôt de la première couche (10) pour isoler les pattes de connexion (4) des composants électroniques (A, B, C) à refroidir, et à mettre également en contact le drain thermique (12) avec les parties des composants (A, B, C) non recouvertes par la première couche (10).

3. Procédé selon la revendication 1 ou 2, caractérisé en ce qu'il consiste à utiliser les mêmes matériaux pour réaliser les première et seconde couches (10, 14).

4. Procédé selon l'une quelconque des revendications 1 à 3, caractérisé en ce qu'il consiste à déposer les première et seconde couches (10, 14) par coulage.

5. Procédé selon l'une quelconque des revendications précédentes, caractérisé en ce qu'il consiste à réaliser la structure métallique souple du drain (12) sous la forme d'une enveloppe ou chaussette dans laquelle la carte (1) est insérée pour assurer également un blindage électromagnétique.

6. Dispositif de dissipation de l'énergie thermique produite par des composants électroniques (A, B, C) implantés sur une carte (1) à circuits imprimés, le dispositif comprenant une première couche (10) en un premier matériau thermiquement conducteur et électriquement isolant, qui est déposé sur la carte (1) pour isoler au moins les pattes de connexion (4) des composants électroniques (A, B, C) à refroidir, et un drain métallique (12) en contact avec la première couche (10) et relié à une masse thermique pour drainer les calories vers l'extérieur, caractérisé en ce que le drain (12) est d'une structure souple et poreuse, et en ce que le dispositif comprend également une seconde couche (14) d'un second matériau, qui est déposée sur le drain (12) et qui adhère à la première couche (10) au travers des pores du drain (12).

7. Dispositif selon la revendication 6, caractérisé en ce que le drain (12) est directement en contact avec certains des composants (B, C) à refroidir.

8. Dispositif selon la revendication 6 ou 7, caractérisé en ce que le drain (12) est constitué par une mousse métallique à cellules ouvertes.

9. Dispositif selon la revendication 6 ou 7, caractérisé en ce que le drain (12) est réalisé sous la forme d'un ruban à structure en treillis.

10. Dispositif selon la revendication 6 ou 7, caractérisé en ce que le drain métallique (12) est réalisé à partir d'au moins un fil (20) plié et replié de manière à former un volume à pores ou à alvéoles communiquantes.

11. Dispositif selon l'une quelconque des revendications 6 à 10, caractérisé en ce que drain (12) est constitué par une enveloppe ou chaussette dans laquelle vient se loger la carte (1) pour former également un blindage électromagnétique.

12. Dispositif selon l'une quelconque des revendications 6 à 11, caractérisé en ce que les matériaux constituant les première et seconde couches (10, 14) sont les mêmes, une résine du type polyuréthanne par exemple.

## Patentansprüche

1. Herstellungsverfahren einer Vorrichtung zur Abfuhr von Wärme, das durch auf einer Leiterplatte (1) angeordnete Schaltkreise (A, B, C) hergestellt wird, wobei das Verfahren besteht darin, auf die Leiterplatte (1) eine erste Schicht (10) eines ersten thermisch leitenden und elektrisch isolierenden Materials aufzutragen, die zumindest die Verbindungsklappen (4) der Schaltkreise (A, B, C) abdeckt und somit abkühlt, und diese erste Schicht (10) mit einem Metalldrain (12) in Kontakt zu bringen, die mit einer thermischen Masse verbunden ist, um die Kalorien an die Ränder der Leiterplatte zu führen, dadurch gekennzeichnet, daß das Verfahren darin besteht, der Drain (12) aus einer weichen, porösen Struktur herzustellen und auf dem Drain (12) eine zweite Schicht (14) eines weiteren Materials anzubringen, die durch die Poren des Drains (12) hindurch an der ersten Schicht (10) klebt, um den Drain auf der Leiterplatte (1) zu fixieren.

2. Verfahren nach Anspruch 1, dadurch gekennzeichnet, daß es darin besteht, die Stärke der Ablagerung der ersten Schicht (10) zu beschränken, um die Verbindungsklappen (4) der Schaltkreise (A, B, C) zu isolieren und somit abzukühlen, und anschließend der thermische Drain (12) in Kontakt mit den nicht durch die erste Schicht (10) abgedeckten Teilen der Schaltkreise (A, B, C) zu bringen.

3. Verfahren nach Anspruch 1 oder 2, dadurch gekennzeichnet, daß es darin besteht, zur Herstellung der ersten und der zweiten Schicht (10, 14) die gleichen Materialien zu verwenden.

4. Verfahren nach einem der Ansprüche 1 bis 3, dadurch gekennzeichnet, daß es darin besteht, die erste und die zweite Schicht (10, 14) aufzugiessen.

5. Verfahren nach einem der Ansprüche 1 bis 4, dadurch gekennzeichnet, daß es darin besteht, die weiche metallische Struktur des Drains (12) in Form eines Umschlags oder Sockens herzustellen, in den die Leiterplatte (1) eingelassen wird, um auch einen elektromagnetischen Schutz zu gewährleisten.

6. Vorrichtung zur Abfuhr von Wärme, die von auf einer Leiterplatte (1) angeordneten Schaltkreisen (A, B, C) erzeugt wird, wobei die Vorrichtung enthält eine erste Schicht (10) eines ersten elektrisch isolierenden und thermisch leitenden Materials, die auf die Leiterplatte (1) angebracht ist, um zumindest die Verbindungsklappen (4) der Schaltkreise (A, B, C) zu isolieren und somit abzukühlen, und ein Metalldrain (12) in Kontakt mit der ersten Shicht (10), die mit einer thermischen Masse verbunden ist, um die Kalorien an die Ränder der Leiterplatte (1) zu führen, dadurch gekennzeichnet, daß der Drain (12) aus einer weichen, porösen Struktur hergestellt wird und daß die Vorrichtung auch eine zweite Schicht (14) eines weiteren Materials enthält, die auf dem Drain (12) angebracht wird und die durch die Poren des Drains (12) hindurch an der ersten Schicht (10) klebt.

7. Vorrichtung nach Anspruch 6, dadurch gekennzeichnet, daß der Drain (12) in direkten Kontakt mit den Schaltkreisen (B, C) gebracht wird, die abgekühlt werden.

8. Vorrichtung nach Anspruch 6 oder 7, dadurch gekennzeichnet, daß der Drain (12) aus metallischen Schaum mit offenen Zellen gebildet wird.

9. Vorrichtung nach Anspruch 6 oder 7, dadurch gekennzeichnet, daß der Drain (12) in Form eines Bandes mit Gitterstruktur hergestellt wird.

10. Vorrichtung nach Anspruch 6 oder 7, dadurch gekennzeichnet, daß der Drain (12) zumindest aus einem mehrfach gefalteten Draht (20) mit einem Volumen aus Poren oder übertragenden Zellen hergestellt wird.

11. Vorrichtung nach einem der Ansprüche 6 bis 10, dadurch gekennzeichnet, daß der Drain (12) aus einem Umschlag oder einem Socken besteht, in den die Leiterplatte (1) eingebettet ist, um auch einen elektromagnetischen Schutz zu bilden.

12. Vorrichtung nach einem der Ansprüche 6 bis 11, dadurch gekennzeichnet, daß die gleichen Materialien zur Herstellung der ersten Shicht und der zweiten Schicht (10, 14) verwandt werden, z.B. Harz auf der Basis von Polyurethan.

## Claims

1. A method for manufacturing a device to dissipate the thermal energy produced by electronic components (A, B, C) embedded in a printed circuit card (1), such method consisting in depositing on the card (1) a first layer (10) of a first thermally conductive and electrically insulating material to cover at least the connecting tabs (4) for the electronic components (A, B, C) to be cooled, and putting this first layer (10) in contact with a metallic drain (12) connected to a thermal mass to drain the calories towards the exterior of the card, characterised in that the method consisting is making the drain (12) in the form of a flexible porous structure, and in depositing on the drain (12) a second layer (14) of a second material that adheres to the first layer (10) through the pores of the drain (12) to hold the latter in place on the card (1).

2. A method according to Claim 1, characterised in that it consists in limiting the deposit thickness of the first layer (10) so as to insulate only the connecting tabs (4) of the electronic components (A, B, C) to be cooled and to put the thermal drain (12) into contact with those parts of these components (A, B, C) that are not covered by the first layer (10).

3. A method according to Claims 1 or 2, characterised in that it consists in using the same materials for the first and second layers (10, 14).

4. A method according to any one of Claims 1 to 3, characterised in that it consists in depositing the first and second layers (10, 14) by casting.

5. A method according to any one of the above Claims, characterised in that it consists in making the flexible metallic structure of the drain (12) in the form of an envelope or sleeve in which the card (1) is inserted so as to also ensure electromagnetic shielding.

6. A device for dissipating thermal energy produced by electronic components (A, B, C) embedded in a printed circuit card (1), the device comprising a first layer (10) of a thermally conductive and electrically insulating material that is deposited on the card (1) to insulate at least the connecting tabs (4) of the electronic components (A, B, C) to be cooled, and a metallic drain (12) in contact with the first layer (10) and connected to a thermal mass to drain the calories towards the exterior, characterised in that the drain (12) is a flexible porous structure, and in that the device also comprises a second layer (14) of a second material that is deposited on the drain (12) and that adheres to the first layer (10) through the pores of the drain (12).

7. A device according to Claim 6, characterised in that the drain (12) is in direct contact with certain of the components (B, C) to be cooled.

8. A device according to Claims 6 or 7, characterised in that the drain (12) is constituted by an open cell metallic foam.

9. A device according to Claims 6 or 7, characterised in that the drain (12) is made in the form of a band of a thickness having a lattice structure.

10. A device according to Claims 6 or 7, characterised in that the metallic drain (12) is made of at least one filament plied so as to form a volume having communicating pores or cells.

11. A device according to any one of Claims 6 to 10, characterised in that the drain (12) is constituted by an envelope or sleeve in which the card (1) is inserted so as to also form an electromagnetic shield.

12. A device according to any one of Claims 6 to 11, characterised in that the materials constituting the first and second layers (10, 14) are the same, a polyurethane type resin for example.
